# EUROPEAN PATENT APPLICATION

(11) **EP 4 550 391 A1**
(43) Date of publication of application: **07.05.2025**
(21) Application number: 24172388.1
(22) Date of filing: 25.04.2024
(51) Int. Cl.: H01L 21/56, H01L 23/31, H01L 23/00, H01L 23/28

(54) **METHOD FOR FABRICATING SEMICONDUCTOR PACKAGING STRUCTURE AND SEMICONDUCTOR PACKAGING STRUCTURE FABRICATED USING THE SAME**

(30) Priority: 02.11.2023 CN 202311446863
(71) Applicant: Delta Electronics, Inc., Taoyuan City 33341 (TW)
(72) Inventor: CHIANG, Hsin-Chun, Taoyuan City (TW); TSAI, Chang-Chin, Taoyuan City (TW); CHEN, Jung-Li, Taoyuan City (TW); TSAI, Yu-Hsuan, Taoyuan City (TW)
(74) Representative: 2K Patentanwälte Blasberg Kewitz & Reichel

(57) **Abstract**

A method for fabricating a semiconductor packaging structure is provided. The fabrication method includes providing a lower mold. The fabrication method includes disposing a plurality of semiconductor components on the lower mold. The fabrication method includes disposing a plurality of first metal structures on the lower mold, wherein the first metal structures are located on both sides of the semiconductor components. The fabrication method includes providing an upper mold to assemble with the lower mold to accommodate the semiconductor components and the first metal structures. The fabrication method includes filling a packaging material between the lower mold and the upper mold. The fabrication method includes removing the upper mold, the lower mold and the first metal structures to form a plurality of through holes in the packaging material located on both sides of the semiconductor components.

## Description

### CROSS REFERENCE TO RELATED APPLICATIONS

This Application claims priority of China Patent Application No. 202311446863.7, filed on November 2, 2023, the entirety of which is incorporated by reference herein.

### BACKGROUND OF THE INVENTION

### Field of the Invention

The present invention relates to a method for fabricating a semiconductor packaging structure, and, in particular, to a method for fabricating a semiconductor packaging structure by disposing posts.

### Description of the Related Art

For current power modules molded with epoxy resin, the structural features of the product are designed on the mold. However, different molds need to be designed for products with different structural characteristics. That is, the molds are not interchangeable, resulting in high mold manufacturing costs.

Also, the production of products with complex structural features is often limited by the capabilities of the molding process.

### BRIEF SUMMARY OF THE INVENTION

In accordance with one embodiment of the present disclosure, a method for fabricating a semiconductor packaging structure is provided. The fabrication method includes providing a lower mold. The fabrication method includes disposing a plurality of semiconductor components on the lower mold. The fabrication method includes disposing a plurality of first metal structures on the lower mold, wherein the first metal structures are located on both sides of the semiconductor components. The fabrication method includes providing an upper mold to assemble with the lower mold to accommodate the semiconductor components and the first metal structures. The fabrication method includes filling a packaging material between the lower mold and the upper mold. The fabrication method includes removing the upper mold, the lower mold and the first metal structures to form a plurality of through holes in the packaging material located on both sides of the semiconductor components.

In some embodiments, the step of disposing the semiconductor components and the first metal structures on the lower mold includes providing a carrier; disposing a tape on the carrier; disposing the semiconductor components and the first metal structures on the tape; and disposing the carrier on the lower mold.

In some embodiments, the step of disposing the semiconductor components on the lower mold includes providing a carrier; disposing the semiconductor components on the carrier; and transferring the semiconductor components to the lower mold. In some embodiments, the method for fabricating a semiconductor packaging structure further includes transferring the semiconductor components to the lower mold through a plurality of second metal structures disposed on the lower mold. In some embodiments, the step of disposing the first metal structures on the lower mold includes locking the first metal structures to the upper mold; and assembling the upper mold and the lower mold.

In some embodiments, the method for fabricating a semiconductor packaging structure further includes cutting the packaging material to form a plurality of semiconductor packaging structures, wherein each semiconductor packaging structure includes a semiconductor component, a packaging material covering the semiconductor component, and through holes penetrating the packaging material. In some embodiments, in each of the semiconductor packaging structures, the packaging material has a first sidewall and a second sidewall opposite the first sidewall, and the angle between the first sidewall and the second sidewall and the horizontal plane is 90 degrees.

In accordance with one embodiment of the present disclosure, a semiconductor packaging structure which is fabricated by the disclosed method for fabricating a semiconductor packaging structure is provided.

In some embodiments, the packaging material has a first sidewall and a second sidewall opposite the first sidewall, and the angle between the first sidewall and the second sidewall and the horizontal plane is 90 degrees.

In some embodiments, the semiconductor packaging structure further includes a plurality of positioning holes located on both sides of the semiconductor component, wherein the positioning holes are closer to the semiconductor component than the through holes.

In the present disclosure, when products of different sizes or structural features are to be produced, there is no need to design different molds. That is, different products can share the same mold, and only through the structural design of the detachable posts and subsequent cutting procedures, the required products can be produced. Through the disclosed process technology, the commonality of molds can be increased and the cost of mold development can be saved.

Since there is no need to design the structural features of the product on the mold, the structural strength of the mold is also improved, making the mold more tolerable. In addition, The present disclosure utilizes cutting and molding technology after demolding to easily produce products with vertical sides, overcoming traditional manufacturing process limitations.

### BRIEF DESCRIPTION OF THE DRAWINGS

The disclosure can be more fully understood from the following detailed description when read with the accompanying figures. It is worth noting that in accordance with standard practice in the industry, various features are not drawn to scale. In fact, the dimensions of the various features may be arbitrarily increased or reduced for clarity of discussion.
FIG. 1 shows a cross-sectional view of a mold-cladding semiconductor structure in accordance with one embodiment of the present disclosure;
FIG. 2 shows a cross-sectional view of a mold-cladding semiconductor structure in accordance with one embodiment of the present disclosure;
FIGS. 3A-3H show cross-sectional views of a method for fabricating a semiconductor packaging structure in accordance with one embodiment of the present disclosure; and
FIGS. 4A-4F show cross-sectional views of a method for fabricating a semiconductor packaging structure in accordance with one embodiment of the present disclosure.

### DETAILED DESCRIPTION OF THE INVENTION

Various embodiments or examples are provided in the following description to implement different features of the present disclosure. The elements and arrangement described in the following specific examples are merely provided for introducing the present disclosure and serve as examples without limiting the scope of the present disclosure. For example, when a first component is referred to as "on a second component", it may directly contact the second component, or there may be other components in between, and the first component and the second component do not come in direct contact with one another.

It should be understood that additional operations may be provided before, during, and/or after the described method. In accordance with some embodiments, some of the stages (or steps) described below may be replaced or omitted.

In this specification, spatial terms may be used, such as "below", "lower", "above", "higher" and similar terms, for briefly describing the relationship between an element relative to another element in the figures. Besides the directions illustrated in the figures, the components may be used or operated in different directions. When the component is turned to different directions (such as rotated 45 degrees or other directions), the spatially related adjectives used in it will also be interpreted according to the turned position. In some embodiments of the present disclosure, terms concerning attachments, coupling and the like, such as "connected" and "interconnected," refer to a relationship wherein structures are secured or attached to one another either directly or indirectly through intervening structures, as well as both movable or rigid attachments or relationships, unless expressly described otherwise.

Herein, the terms "about", "around" and "substantially" typically mean a value is in a range of +/- 15% of a stated value, typically a range of +/- 10% of the stated value, typically a range of +/- 5% of the stated value, typically a range of +/- 3% of the stated value, typically a range of +/- 2% of the stated value, typically a range of +/- 1% of the stated value, or typically a range of +/- 0.5% of the stated value. The stated value of the present disclosure is an approximate value. Namely, the meaning of "about", "around" and "substantially" may be implied if there is no specific description of "about", "around" and "substantially".

It should be understood that, although the terms "first", "second", "third", etc. may be used herein to describe various elements, components, regions, layers, portions and/or sections, these elements, components, regions, layers, portions and/or sections should not be limited by these terms. These terms are only used to distinguish one element, component, region, layer, portion or section from another element, component, region, layer, portion or section. Thus, a first element, component, region, layer, portion or section discussed below could be termed a second element, component, region, layer, portion or section without departing from the teachings of the present disclosure.

Unless defined otherwise, all technical and scientific terms used herein have the same meaning as commonly understood by one of ordinary skill in the art to which this disclosure belongs. It should be appreciated that, in each case, the term, which is defined in a commonly used dictionary, should be interpreted as having a meaning that conforms to the relative skills of the present disclosure and the background or the context of the present disclosure, and should not be interpreted in an idealized or overly formal manner unless so defined.

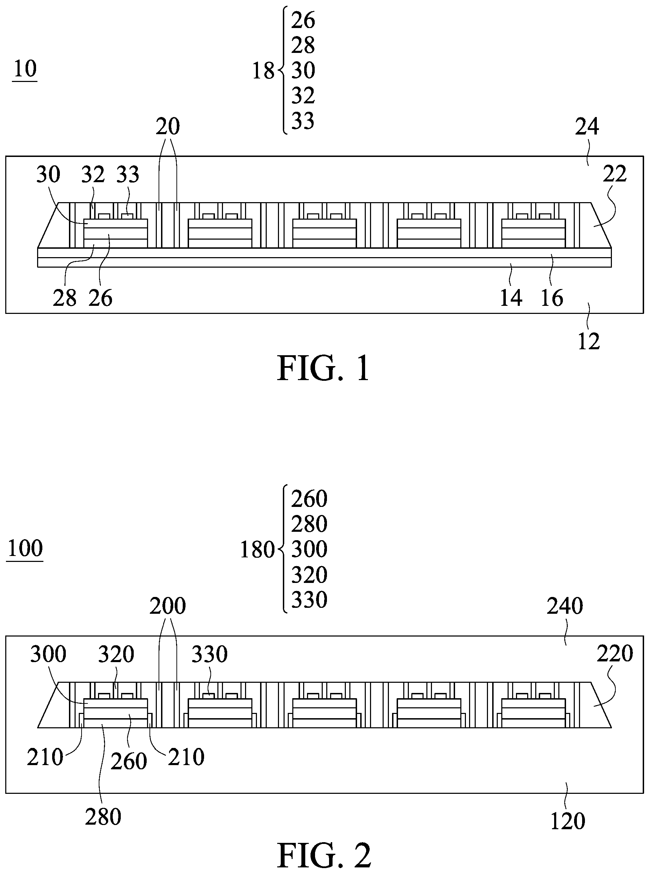

Referring to FIG. 1, in accordance with one embodiment of the present disclosure, a mold-cladding semiconductor structure 10 is provided. FIG. 1 shows a cross-sectional view of the mold-cladding semiconductor structure 10.

As shown in FIG. 1, the mold-cladding semiconductor structure 10 includes a lower mold 12, a carrier 14, a tape 16, a plurality of semiconductor components 18, a plurality of first metal structures 20, a packaging material 22, and an upper mold 24. The semiconductor components 18 are disposed on the lower mold 12. The carrier 14 is disposed between the lower mold 12 and the semiconductor components 18. The tape 16 is disposed between the carrier 14 and the semiconductor components 18. The first metal structures 20 are disposed on the lower mold 12 and located on both sides of the semiconductor components 18. In more detail, the semiconductor components 18 and the first metal structures 20 are disposed on the tape 16 and in contact with the tape 16. The packaging material 22 is filled between the lower mold 12 and the upper mold 24. The first metal structures 20 penetrate the packaging material 22. The upper mold 24 is assembled with the lower mold 12 to accommodate the semiconductor components 18 and the first metal structures 20.

In some embodiments, the carrier 14 may include metal, but the present disclosure is not limited thereto, and other suitable hard materials with heat-resistant, pressure-resistant and support properties are also applicable to the present disclosure. In some embodiments, the tape 16 may include heat-resistant tape, but the present disclosure is not limited thereto, and other suitable materials with heat-resistant, pressure-resistant and adhesive properties are also applicable to the present disclosure.

In some embodiments, the semiconductor components 18 may include power components, but the present disclosure is not limited thereto. In some embodiments, the semiconductor component 18 may include a substrate 26, a first metal layer 28, a second metal layer 30, a conductive component 32, and a chip 33. The first metal layer 28 and the second metal layer 30 are disposed on opposite sides of the substrate 26. The first metal layer 28 is in contact with the tape 16. The conductive component 32 is disposed on the second metal layer 30 to connect to an external circuit (not shown). The chip 33 is disposed on the second metal layer 30, as shown in FIG. 1.

In some embodiments, the first metal structures 20 may include columnar metal structures, for example, cylindrical metal structures, but the present disclosure is not limited thereto, and other suitable three-dimensional shapes are also applicable to the present disclosure, and may be designed according to product requirements. In some embodiments, between the adjacent semiconductor components 18, a plurality of first metal structures 20 may be included. For example, between the adjacent semiconductor components 18, there is an even number of the first metal structures 20, so that a semiconductor packaging structure formed after cutting has symmetrical through holes for subsequent screw locking, but the present disclosure is not limited thereto, and other suitable locations and quantities of the first metal structures 20 are also applicable to the present disclosure, and may be designed according to product requirements.

In some embodiments, the packaging material 22 may include solid molding materials, liquid molding materials, anisotropic conductive film (ACF), or sheet molding materials, but the present disclosure is not limited thereto, and other suitable molding materials are also applicable to the present disclosure.

Referring to FIG. 2, in accordance with one embodiment of the present disclosure, a mold-cladding semiconductor structure 100 is provided. FIG. 2 shows a cross-sectional view of the mold-cladding semiconductor structure 100.

As shown in FIG. 2, the mold-cladding semiconductor structure 100 includes a lower mold 120, a plurality of semiconductor components 180, a plurality of first metal structures 200, a plurality of second metal structures 210, a packaging material 220, and an upper mold 240. The semiconductor components 180 are disposed on the lower mold 120. The first metal structures 200 are disposed on the lower mold 120 and located on both sides of the semiconductor components 180. The second metal structures 210 are disposed on the lower mold 120 and located on both sides of the semiconductor components 180. In more detail, the semiconductor components 180, the first metal structures 200 and the second metal structures 210 are disposed on the lower mold 120 and in contact with the lower mold 120. The second metal structures 210 are closer to the semiconductor component 180 than the first metal structures 200. The packaging material 220 is filled between the lower mold 120 and the upper mold 240. The first metal structures 200 penetrate the packaging material 220. The upper mold 240 is assembled with the lower mold 120 to accommodate the semiconductor components 180, the first metal structures 200 and the second metal structures 210.

In some embodiments, the semiconductor components 180 may include power components, but the present disclosure is not limited thereto. In some embodiments, the semiconductor component 180 may include a substrate 260, a first metal layer 280, a second metal layer 300, a conductive component 320, and a chip 330. The first metal layer 280 and the second metal layer 300 are disposed on opposite sides of the substrate 260. The first metal layer 280 is in contact with the lower mold 120. The conductive component 320 is disposed on the second metal layer 300 to connect to an external circuit (not shown). The chip 330 is disposed on the second metal layer 300, as shown in FIG. 2.

In some embodiments, the first metal structures 200 may include columnar metal structures, for example, cylindrical metal structures, but the present disclosure is not limited thereto, and other suitable three-dimensional shapes are also applicable to the present disclosure, and may be designed according to product requirements. In some embodiments, between the adjacent semiconductor components 180, a plurality of first metal structures 200 may be included. For example, between the adjacent semiconductor components 180, there is an even number of the first metal structures 200, so that a semiconductor packaging structure formed after cutting has symmetrical through holes for subsequent screw locking, but the present disclosure is not limited thereto, and other suitable locations and quantities of the first metal structures 200 are also applicable to the present disclosure, and may be designed according to product requirements.

In some embodiments, the second metal structures 210 may include columnar metal structures, for example, cylindrical metal structures, but the present disclosure is not limited thereto, and other suitable three-dimensional shapes are also applicable to the present disclosure, and may be designed according to product requirements. In the present disclosure, the second metal structure 210 is disposed at a specific position on the lower mold 120 to serve as a positioning post for transferring the semiconductor component 180 to the lower mold 120, so that the semiconductor component 180 can be smoothly disposed at a predetermined position on the lower mold 120.

In some embodiments, the packaging material 220 may include solid molding materials, liquid molding materials, anisotropic conductive film (ACF), or sheet molding materials, but the present disclosure is not limited thereto, and other suitable molding materials are also applicable to the present disclosure.

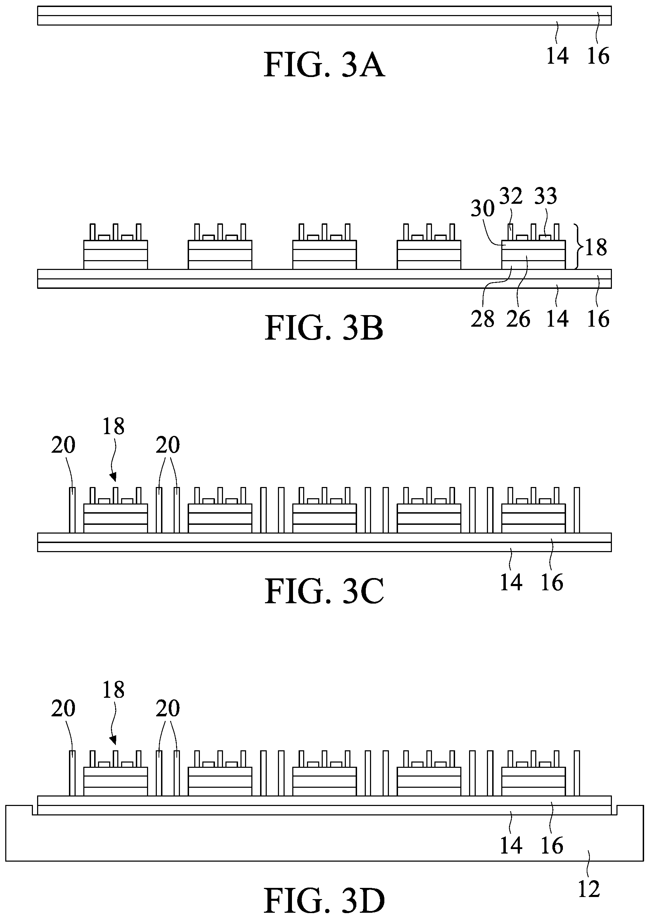

Referring to FIGS. 3A-3H, in accordance with one embodiment of the present disclosure, a method for fabricating a semiconductor packaging structure is provided. FIGS. 3A-3H show cross-sectional views of the method for fabricating the semiconductor packaging structure.

As shown in FIG. 3A, a carrier 14 is provided. A tape 16 is attached to the carrier 14.

As shown in FIG. 3B, a plurality of semiconductor components 18 are attached to the tape 16. The semiconductor component 18 includes a substrate 26, a first metal layer 28, a second metal layer 30, a conductive component 32, and a chip 33. The first metal layer 28 and the second metal layer 30 are disposed on opposite sides of the substrate 26. The first metal layer 28 is in contact with the tape 16. The conductive component 32 is disposed on the second metal layer 30 for subsequent connection to external circuits. The chip 33 is disposed on the second metal layer 30.

As shown in FIG. 3C, a plurality of first metal structures 20 are attached to the tape 16 and located on both sides of the semiconductor components 18. The positions where the first metal structures 20 are attached to the tape 16 are the positions where the through holes are subsequently formed.

As shown in FIG. 3D, a lower mold 12 is provided. The carrier 14 with the tape 16, the semiconductor components 18 and the first metal structures 20 disposed thereon is disposed on the lower mold 12. That is, the semiconductor components 18 and the first metal structures 20 are disposed on the lower mold 12.

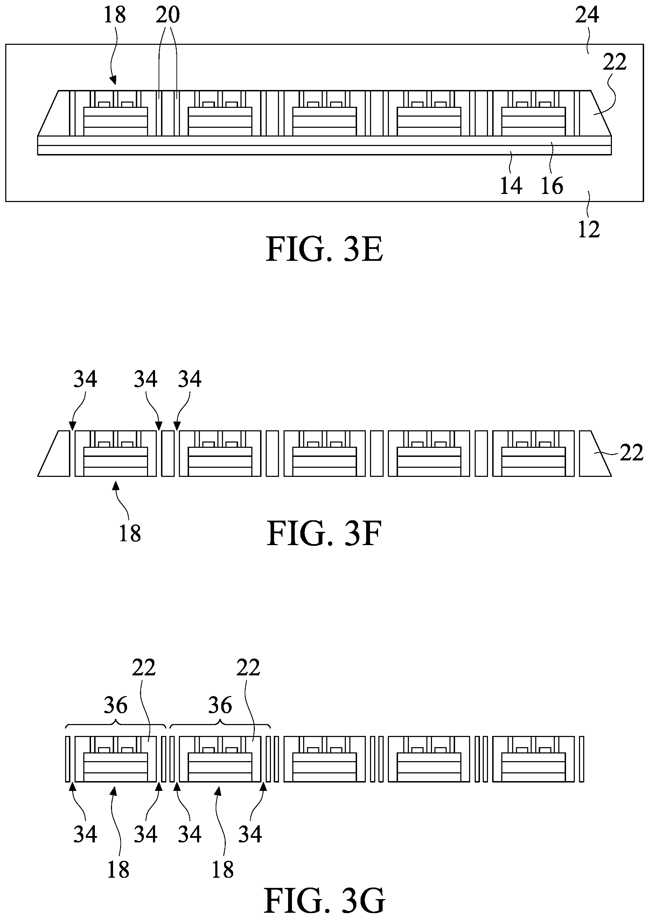

As shown in FIG. 3E, an upper mold 24 is provided. The upper mold 24 is assembled with the lower mold 12 to accommodate the semiconductor components 18 and the first metal structures 20. After assembling the upper mold 24 and the lower mold 12, a packaging material 22 is injected and filled between the lower mold 12 and the upper mold 24.

As shown in FIG. 3F, after filling the packaging material 22, the upper mold 24, the lower mold 12, the first metal structures 20, the carrier 14 and the tape 16 are removed to form a plurality of through holes 34 in the packaging material 22 on both sides of the semiconductor components 18.

As shown in FIG. 3G, the packaging material 22 is cut, for example, by laser cutting, to form a plurality of first semiconductor packaging structures 36. Each first semiconductor packaging structure 36 includes the semiconductor component 18, the packaging material 22 covering the semiconductor component 18, and the through holes 34 penetrating the packaging material 22.

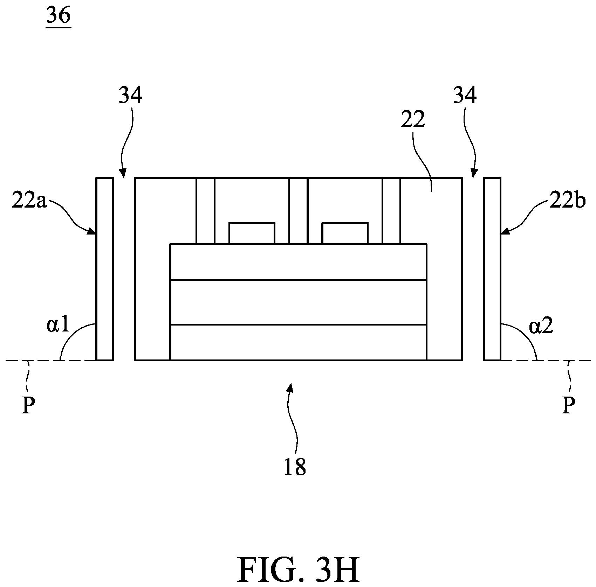

As shown in FIG. 3H, in each first semiconductor packaging structure 36, the packaging material 22 has a first sidewall 22a and a second sidewall 22b opposite the first sidewall 22a, and the angle between the first sidewall 22a and the second sidewall 22b and the horizontal plane P is 90 degrees. For example, the first angle α1 between the first sidewall 22a of the packaging material 22 and the horizontal plane P is 90 degrees. The second angle α2 between the second sidewall 22b of the packaging material 22 and the horizontal plane P is 90 degrees. So far, the fabrication of the disclosed semiconductor packaging structure is completed.

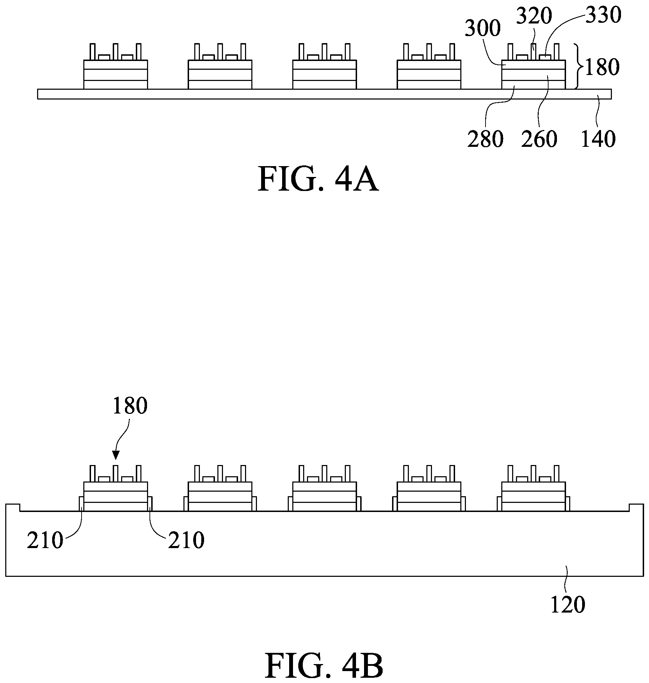

Referring to FIGS. 4A-4F, in accordance with one embodiment of the present disclosure, a method for fabricating a semiconductor packaging structure is provided. FIGS. 4A-4F show cross-sectional views of the method for fabricating the semiconductor packaging structure.

As shown in FIG. 4A, a carrier 140 is provided. A plurality of semiconductor components 180 are disposed on the carrier 140. The semiconductor component 180 includes a substrate 260, a first metal layer 280, a second metal layer 300, a conductive component 320, and a chip 330. The first metal layer 280 and the second metal layer 300 are disposed on opposite sides of the substrate 260. The conductive component 320 is disposed on the second metal layer 300 for subsequent connection to external circuits. The chip 330 is disposed on the second metal layer 300.

As shown in FIG. 4B, a lower mold 120 is provided, wherein a plurality of second metal structures 210 are disposed at specific positions on the lower mold 120 to serve as positioning posts for transferring the semiconductor components 180 on the carrier 140 to the lower mold 120. The semiconductor components 180 are transferred to the lower mold 120 through the second metal structures 210 disposed on the lower mold 120, so that the semiconductor components 180 are disposed at predetermined positions on the lower mold 120.

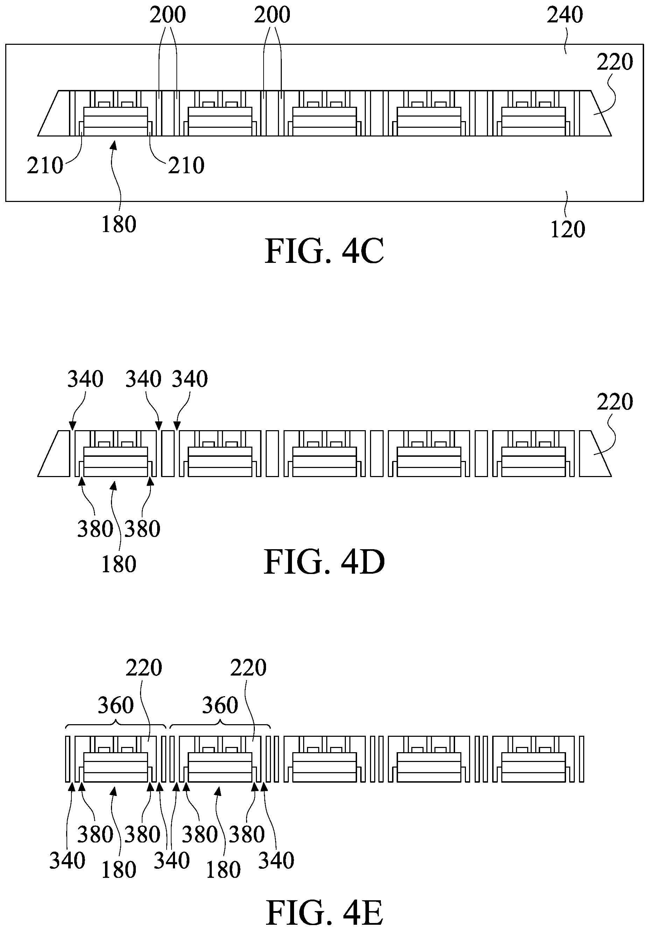

As shown in FIG. 4C, an upper mold 240 is provided. A plurality of first metal structures 200 are locked to the upper mold 240. The upper mold 240 with the first metal structures 200 locked thereon is assembled with the lower mold 120 to accommodate the semiconductor components 180, the first metal structures 200, and the second metal structures 210. That is, the semiconductor components 180, the first metal structures 200, and the second metal structures 210 are disposed on the lower mold 120, wherein the first metal structures 200 and the second metal structures 210 are respectively located on both sides of the semiconductor component 180, and the second metal structures 210 are closer to the semiconductor component 180 than the first metal structures 200. Specifically, the positions of the first metal structures 200 are the positions where the through holes are subsequently formed. After the upper mold 240 is assembled with the lower mold 120, a packaging material 220 is injected and filled between the lower mold 120 and the upper mold 240.

As shown in FIG. 4D, after the packaging material 220 is filled, the upper mold 240, the lower mold 120, the first metal structures 200 and the second metal structures 210 are removed to form a plurality of through holes 340 and a plurality of positioning holes 380 in the packaging material 220. The through holes 340 and the positioning holes 380 are respectively located on both sides of the semiconductor component 180, wherein the positioning holes 380 are closer to the semiconductor component 180 than the through holes 340.

As shown in FIG. 4E, the packaging material 220 is cut, for example, by laser cutting, to form a plurality of second semiconductor packaging structures 360. Each of the second semiconductor packaging structures 360 includes a semiconductor component 180, a packaging material 220 covering the semiconductor component 180, through holes 340 penetrating the packaging material 220 and positioning holes 380 adjacent to the semiconductor component 180.

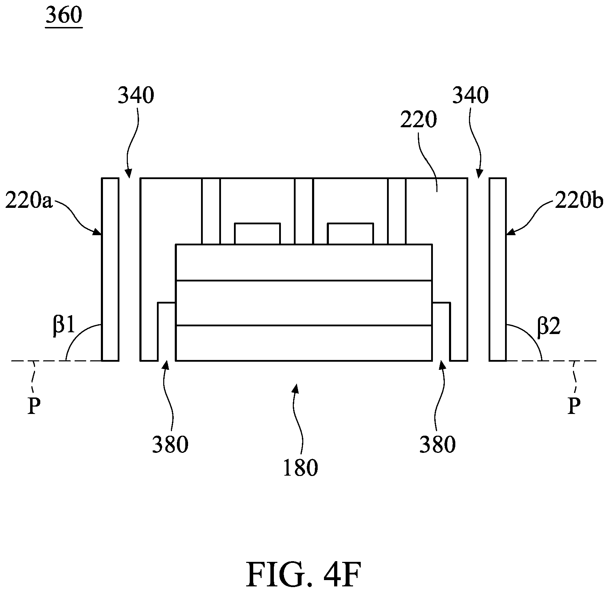

As shown in FIG. 4F, in each second semiconductor packaging structure 360, the packaging material 220 has a first sidewall 220a and a second sidewall 220b opposite the first sidewall 220a, and the angle between the first sidewall 220a and the second sidewall 220b and the horizontal plane P is 90 degrees. For example, the first angle β1 between the first sidewall 220a of the packaging material 220 and the horizontal plane P is 90 degrees. The second angle β2 between the second sidewall 220b of the packaging material 220 and the horizontal plane P is 90 degrees. So far, the fabrication of the disclosed semiconductor packaging structure is completed.

In the present disclosure, when products of different sizes or structural features are to be produced, there is no need to design different molds. That is, different products can share the same mold, and only through the structural design of the detachable posts and subsequent cutting procedures, the required products can be produced. Through the disclosed process technology, the commonality of molds can be increased and the cost of mold development can be saved.

Since there is no need to design the structural features of the product on the mold, the structural strength of the mold is also improved, making the mold more tolerable. In addition, The present disclosure utilizes cutting and molding technology after demolding to easily produce products with vertical sides, overcoming traditional manufacturing process limitations.

Although some embodiments of the present disclosure and their advantages have been described in detail, it should be understood that various changes, substitutions and alterations can be made herein without departing from the spirit and scope of the disclosure as defined by the appended claims. The features of the various embodiments can be used in any combination as long as they do not depart from the spirit and scope of the present disclosure. Moreover, the scope of the present application is not intended to be limited to the particular embodiments of the process, machine, manufacture, composition of matter, means, methods and steps described in the specification. As one of ordinary skill in the art will readily appreciate from the present disclosure, processes, machines, manufacture, compositions of matter, means, methods, or steps, presently existing or later to be developed, that perform substantially the same function or achieve substantially the same result as the corresponding embodiments described herein may be utilized according to the present disclosure. Accordingly, the appended claims are intended to include within their scope such processes, machines, manufacture, compositions of matter, means, methods or steps. In addition, each claim constitutes an individual embodiment, and the claimed scope of the present disclosure includes the combinations of the claims and embodiments. The scope of protection of present disclosure is subject to the definition of the scope of the appended claims. Any embodiment or claim of the present disclosure does not need to meet all the purposes, advantages, and features disclosed in the present disclosure.

## Claims

1. A method for fabricating a semiconductor packaging structure, comprising:
providing a lower mold;
disposing a plurality of semiconductor components on the lower mold;
disposing a plurality of first metal structures on the lower mold, wherein the first metal structures are located on both sides of the semiconductor components;
providing an upper mold to assemble with the lower mold to accommodate the semiconductor components and the first metal structures;
filling a packaging material between the lower mold and the upper mold; and
removing the upper mold, the lower mold and the first metal structures to form a plurality of through holes in the packaging material located on both sides of the semiconductor components.

2. The method for fabricating a semiconductor packaging structure as claimed in claim 1, wherein the step of disposing the semiconductor components and the first metal structures on the lower mold comprises:
providing a carrier;
disposing a tape on the carrier;
disposing the semiconductor components and the first metal structures on the tape; and
disposing the carrier on the lower mold.

3. The method for fabricating a semiconductor packaging structure as claimed in claim 1, wherein the step of disposing the semiconductor components on the lower mold comprises:
providing a carrier;
disposing the semiconductor components on the carrier; and
transferring the semiconductor components to the lower mold.

4. The method for fabricating a semiconductor packaging structure as claimed in claim 3, further comprising transferring the semiconductor components to the lower mold through a plurality of second metal structures disposed on the lower mold.

5. The method for fabricating a semiconductor packaging structure as claimed in claim 3, wherein the step of disposing the first metal structures on the lower mold comprises:
locking the first metal structures to the upper mold; and
assembling the upper mold and the lower mold.

6. The method for fabricating a semiconductor packaging structure as claimed in claim 1, further comprising cutting the packaging material to form a plurality of semiconductor packaging structures, wherein each semiconductor packaging structure comprises the semiconductor component, the packaging material covering the semiconductor component, and the through holes penetrating the packaging material.

7. The method for fabricating a semiconductor packaging structure as claimed in claim 6, wherein, in each semiconductor packaging structure, the packaging material has a first sidewall and a second sidewall opposite the first sidewall, and an angle between the first sidewall and the second sidewall and a horizontal plane is 90 degrees.

8. A semiconductor packaging structure fabricated by the method for fabricating a semiconductor packaging structure as claimed in claim 6.

9. The semiconductor packaging structure as claimed in claim 8, wherein the packaging material has a first sidewall and a second sidewall opposite the first sidewall, and the angle between the first sidewall and the second sidewall and the horizontal plane is 90 degrees.

10. The semiconductor packaging structure as claimed in claim 8, further comprising a plurality of positioning holes located on both sides of the semiconductor component, wherein the positioning holes are closer to the semiconductor component than the through holes.

11. The semiconductor packaging structure as claimed in claim 8, wherein the semiconductor component comprises a power component.

12. The semiconductor packaging structure as claimed in claim 8, wherein the semiconductor component comprises a substrate, a first metal layer, a second metal layer, a conductive component, and a chip, wherein the first metal layer and the second metal layer are disposed on opposite sides of the substrate, the conductive component is disposed on the second metal layer to connect to an external circuit, and the chip is disposed on the second metal layer.
